# EUROPEAN PATENT SPECIFICATION

(11) **EP 1 762 892 B1**
(45) Date of publication and mention of the grant of the patent: **11.07.2012**
(21) Application number: 05765354.5
(22) Date of filing: 28.06.2005
(51) Int. Cl.: G02F 1/133, G03B 21/16, H04N 9/31, H05K 7/20

(54) **Liquid crystal panel, projector with such liquid crystal panels, and liquid cooling system for such a projector**
Flüssigkristallzelle, Projektor mit solchen Flüssigkristallzellen und Flüssigkeitskühlsystem dafür
Panneau à cristaux liquides, projecteur avec de tels panneaux à cristaux liquides, et son système de refroidissement liquide

(30) Priority: 30.06.2004 JP 2004193183; 30.06.2004 JP 2004192851
(43) Date of publication of application: 14.03.2007
(73) Proprietor: HITACHI, LTD., Chiyoda-ku Tokyo 100-8280 (JP)
(72) Inventor: HOSHINO, Masakazu, Hitachi, Ltd., Chiyoda-ku, Tokyo 100-8220 (JP); MINAMITANI, Rintaro, Hitachi, Ltd., Chiyoda-ku, Tokyo 100-8220 (JP); NAGANAWA, Takashi, Hitachi, Ltd., Chiyoda-ku, Tokyo 100-8220 (JP); TERAKADO, Shuichi, Hitachi, Ltd., Chiyoda-ku, Tokyo 100-8220 (JP)
(74) Representative: Beetz & Partner
(86) International application number: PCT/JP2005/011849
(87) International publication number: WO 2006/003898

(56) References cited:
- WO-A1-02/19027
- JP-A- 3 288 187
- JP-A- 4 326 683
- JP-A- 5 216 016
- JP-A- 7 181 463
- JP-A- 11 282 361
- JP-A- 61 059 316
- JP-A- 2002 131 737
- JP-A- 2002 268 038
- JP-A- 2004 012 934
- JP-A- 2004 084 958
- JP-A- 2004 095 891
- JP-A- 2004 117 580
- US-A1- 2003 231 271

## Description

### TECHNICAL FIELD

The present invention relates to a liquid crystal projector for projecting lights from a light source through liquid crystal panels, being called by a "light bulb", and a liquid crystal panel, as an image on a screen, and it relates to, in particular, the structures of a liquid crystal panel, which is applied within such the liquid crystal projector, and also a liquid cooling apparatus for cooling such the liquid crystal panel through a liquid coolant.

### BACKGROUND ARTS

In recent years, within field of a projection apparatus for displaying a color image screen, etc., on a personal computer, through enlarged projection thereof (hereinafter, being called simply by a "projector"), for example, an apparatus has been widely put into practical use, resolving or dividing the light obtained from a light source, such as, a metal halide lamp, etc., for example, into three (3) directions, and projecting them on a screen through a projection lens or the like, after modulating light intensity thereof through each of the liquid crystal panels for use of the three (3) primary colors, i.e., R, G or B, respectively, and composing them by means of a color composing prism, etc.

However, within such a projector, in addition to an enlargement in the number of pixels of the liquid crystal panel (i.e., high definition) for increasing the obtainable definition thereof, there is further obtaining high intension of illumination (i.e., high illuminance) of a light irradiation source (for example, adoption of a metal halide lamp having electric power of 250W or more) accompanying an enlargement of the display screen, etc. For that reason, there is raised up a problem of heat, which is generated from the light irradiation source of such high luminance. In particular, within the projector having such the structures as was mentioned above, the light generated from the light irradiation source is irradiated upon each of the liquid crystal panels for use of three (3) primary colors, R, G or B, to be modulated and/or transmitted on the surface thereof; therefore, if the light intensity (i.e., brightness) of the light irradiation source mentioned above goes up, then the heat generation upon those liquid crystal panels goes up, too, and thereby also affecting ill influences upon the characteristics of the liquid crystal panels.

By the way, conventionally, within such the projector, in general, for the purpose of preventing each of the portions of the apparatus, including the liquid crystal panel mentioned above therein (in particular, a lamp and a controller portion, etc.), from increasing in the temperature thereof, so as to protect it from the ill influences thereof, there is provide a fan for air cooling, with which a cooling wind is introduced from an outside of the apparatus into an inside of a housing of the apparatus, so as to be circulated therein. However, as was mentioned in the above, accompanying with an increase of the light intensity from the light irradiation source in the recent years, it comes to be difficult to suppress the heat generation sufficiently, upon the liquid crystal panels, only through the introduction and the circulation of the cooling wind into an inside of the apparatus by means of the cooling fan mentioned above.

Then, as disclosed in the following Patent Documents 1 to 15 mentioned below, there are already proposed projectors, in which a liquid coolant, such as, a water or the like, is sealed or enclosed within an inside of a space, being defined between a polarizing plate and a glass panel opposing thereto, so that the liquid coolant sealed therein is circulated within the inside of the space with using heat generated from the said liquid crystal panel, and thereby suppressing an increase of temperature due to acceptance of lights upon the liquid crystal panel; i.e., protecting the liquid crystal panel from ill influences due to the increase of temperature thereof. Also, for example, in particular, in the Patent Document 11 mentioned below, there is disclosed a cooling structure, wherein liquid crystal panels for use of three (3) fundamental colors, R, G and B, are formed to surround a photosynthesizing prism, as a whole, so that a coolant is enclosed within an inside thereof, and they are dipped a cooling vessel or container having a stirring or churning means in a part thereof, thereby achieving cooling thereof. In addition thereto, for example, by the Patent Document 15 mentioned below, it is already known a projector, in which the coolant is enclosed within spaces defined between the liquid crystal panel and the polarizing plates, being provided in a front and a rear thereof, while forming connecting flow paths or channels between the spaces in the front and the rear of the liquid crystal panel, and further with using a pump, etc., thereby circulating the coolant filled up within the inside of spaces, actively.

As was mentioned above, within the projector, enclosing the liquid coolant within apart of the liquid crystal panel, thereby circulating the liquid coolant enclosed within an inside thereof with utilizing a convection caused due to the heat generation of the said liquid crystal panel, or circulating it by the stirring means and/or the pump, etc., actively, due to the circulation of the liquid coolant enclosed within the liquid crystal panel, it is possible to achieve the cooling of the liquid crystal panels, more effectively. However, in case of taking the heat generation upon the liquid crystal panels into the consideration, accompanying a remarkable increase of light intensity (i.e., brightness) of a light source within projectors in recent years, the cooling is not sufficient, yet. Then, further, as are known from the following Patent Documents 16 to 19, there are already known the projectors, in which flow channels for the liquid coolant are formed in the liquid crystal panels for use of three (3) fundamental colors, R, G and B, as well as, a heat exchanger is provided in an outside thereof, and further a cooling cycle is built up for circulating the liquid coolant with using a circulation pump, so that the liquid coolant, such as, the water or the like, is circulated within that cooling cycle; i.e., achieving the cooling with higher efficiency. Further, in particular, the Patent Document 19 mentioned above discloses a projector, circulation paths are formed on peripheries of the liquid crystal panels mentioned above, so as to achieve the cooling from that periphery, and they are also formed in a periphery of a light irradiation source, thereby achieving the cooling on the entire body of the projector by the cooling cycle.

Patent Document 1: Japanese Patent Laying-Open No. Hei 3-126011 (1991);
Patent Document 2: Japanese Patent Laying-Open No. Hei 4-54778 (1992);
Patent Document 3: Japanese Patent Laying-Open No. Hei 4-73733 (1992);
Patent Document 4: Japanese Patent Laying-Open No. Hei 4-291230 (1992);
Patent Document 5: Japanese Patent Laying-Open No. Hei 5-107519 (1993);
Patent Document 6: Japanese Patent Laying-Open No. Hei 5-232427 (1993);
Patent Document 7: Japanese Patent Laying-Open No. Hei 6-110040 (1994);
Patent Document 8: Japanese Patent Laying-Open No. Hei 7-248480 (1995);
Patent Document 9: Japanese Patent Laying-Open No. Hei 8-211353 (1996);
Patent Document 10: Japanese Patent Laying-Open No. Hei 11-202411 (1999);
Patent Document 11: Japanese Patent Laying-Open No. 2002-131737 (2002);
Patent Document 12: Japanese Patent Laying-Open No. 2002-214596 (2002);
Patent Document 13: Japanese Patent Laying-Open No. 2003-75918 (2003);
Patent Document 14: Japanese Patent Laying-Open No. 2003-195135 (2003);
Patent Document 15: Japanese Patent Laying-Open No. 2004-12934 (2004);
Patent Document 16: Japanese Patent Laying-Open No. Hei 1-159684 (1989);
Patent Document 17: Japanese Patent Laying-Open No. Hei 5-216016 (1993);
Patent Document 18: Japanese Patent Laying-Open No. Hei 5-264947 (1993); and
Patent Document 19: Japanese Patent Laying-Open No. Hei 11-282361 (1999).

As was mentioned in details in the above, within the projectors relating to the conventional arts, for obtaining the cooling at higher efficiency, from introduction/circulation of cooling wind by means of an air cooling fan, in particular, accompanying with the remarkable increase of the intensity of light source (i.e., the brightness) in recent years, a method is adopted for achieving the cooling, by circulating the liquid coolant within an inside thereof while making the liquid coolant in contact with a part of the liquid crystal panel. Further, for achieving the cooling, much more effectively, there is proposed a method for cooling, forming the flow channel for the liquid within the liquid crystal panel, as well as, providing the heat exchanger and/or the circulation pump in an outside thereof, thereby building up the cooling cycle, so that the liquid coolant is circulated within that cooling cycle. However, in that instance, since the ill influences are large due to heat generation on the liquid crystal panels, in particular, in the projector, therefore, strong demands are made for the flow channel structures, being optimal to increase the cooling efficiency with an aid of the liquid coolant in the said liquid crystal panels.

On the other hand, with the projectors relating to the conventional arts mentioned above, as was mentioned previously, due to the principle thereof, i.e., the lights in three (3) directions obtained from a light source are modulated through the crystal panels for use of three (3) fundamental colors, R, G and B, respectively, and are projected on a screen through a projection lens or the like, after being synthesized by means of a color synthesizing prism or the like, there are generated fluctuations and/or discoloration (or, color shading), etc., on an image projected passing through those liquid crystal panels, for the liquid crystal panels mentioned above, in particular, those achieving cooling with applying the liquid coolant therein as was mentioned above, when bubbles are included within the liquid coolant contacting with or passing through a transparent portion (or a surface) of the liquid crystal panels, of course, and further when difference is generated in the density within the liquid coolant contacting with or passing through due to the difference in the velocity or the difference in temperatures; there is a problem that the projection image is disturbed. Further, also with the conventional arts mentioned above, for example, in the Patent Document 17 mentioned above, there is disclosed the structures for removing the bubbles mixed into the circulating liquid coolant, with provision of a bubble chamber within the circulation cycle of the liquid coolant for cooling the liquid crystal panels.

However, with the cooling structures of the liquid crystal panels in the various kinds of projectors, which are proposed in the various conventional arts mentioned above, in particular, it is still impossible to say that they can provide the structures being suitable for cooling those liquid crystal panels, with applying the cooling cycle circulating the liquid coolant therein, effectively, including picture quality of the pictures projected, in case when they are applied into a liquid projector of the method, in particular, synthesizing the lights in three (3) directions obtained from the light source by means of the prism, after passing through the crystal panels for use of three (3) fundamental colors, R, G and B, respectively.

US-A1-2003/0231271 discloses a display panel assembly suitable for devices using a liquid crystal panel for display control. In the assembly a gap member as a channel for fluid is formed between the display layer and the transparent member so as to radiate heat and cool the assembly by letting cooling fluid flow in the gap. It also teaches forming ducts in the panel case, i.e. along the thick region of the case outside the periphery of the counter substrate and the dustproof panel, so as to cool the case. However, its cooling method has also the image quality problem as mentioned above.

The present invention is accomplished by taking the problems in the conventional arts mentioned above into consideration.

### DISCLOSURE OF THE INVENTION

An object of the present invention is to provide a liquid crystal projector, and further a liquid crystal panel and a liquid cooling apparatus thereof, for it; i.e., in particular, enabling to cool the liquid crystal panels with utilizing the liquid cooling cycle circulating the liquid coolant therein, effectively, and in particular, the difference in density within the liquid coolant passing through the transparent surface of the liquid crystal panel due to the difference in velocity and the difference in temperature, etc., and for that reason, giving such the ill influences upon the picture, hardly, which passes through the liquid crystal panel; thereby obtaining a preferable projection image.

The above objects can be accomplished by the features of the independent claims of the present application.

For accomplishing the object mentioned above, according to the present invention, first of all, there may be provided a liquid crystal projector, comprising: a light source; an optical element for changing the light from said light source into a parallel light, to be divided into three (3) light beams; three (3) kinds of liquid crystal panels for transmitting the three (3) light beams divided by said optical element therethrough, so as to modulate intensity thereof; an optical synthesizing means for synthesizing the three (3) light beams, passing through said three (3) kinds of liquid crystal panels, to be modulate intensity thereof; a projection means for projecting the three (3) light beams, which are synthesized by said optical synthesizing means; and a liquid cooling cycle, including a pump and a radiator therein, for circulating a liquid coolant within said three (3) kinds of liquid crystal panels, so as to conduct cooling thereof, wherein each of said three (3) kinds of liquid crystal panels defines a flow channel for the liquid coolant between a surface of said liquid crystal panel and a transparent member to be disposed opposing thereto, respectively, and further, said flow channel includes a high-resistance flow channel being flat and uniform in thickness thereof, covering a liquid crystal panel area of said liquid crystal panel, and also a buffer portion formed neighboring to a one of upstream side and downstream side of said high-resistance flow channel.

Also, according to the present invention, there may be provided a liquid crystal projector, comprising: a light source; an optical element for changing the light from said light source into a parallel light, to be divided into three (3) light beams; three (3) kinds of liquid crystal panels for transmitting the three (3) light beams divided by said optical element therethrough, so as to modulate intensity thereof; an optical synthesizing means for synthesizing the three (3) light beams, passing through said three (3) kinds of liquid crystal panels, to be modulate intensity thereof; a projection means for projecting the three (3) light beams, which are synthesized by said optical synthesizing means; and a liquid cooling cycle, including a pump and a radiator therein, for circulating a liquid coolant within said three (3) kinds of liquid crystal panels, so as to conduct cooling thereof, wherein each of said three (3) kinds of liquid crystal panels defines a flow channel for the liquid coolant with a surface of said liquid crystal panel and a transparent member to be disposed opposing thereto, respectively, and further, said flow channel includes a high-resistance flow channel being flat and uniform in thickness thereof, covering a liquid crystal panel area of said liquid crystal panel, and also an auxiliary flow channel lower in flow resistance than said high-resistance flow channel, being formed surrounding said high-resistance flow channel.

Next, according to the present invention, also for accomplishing the object mentioned above, there is provided a liquid crystal panel for use in a liquid crystal projector, comprising: two (2) pieces of transparent substrates, enclosing a liquid crystal between them; and further at lease a transparent plate, being disposed opposing to one surface of said two (2) pieces of transparent substrates, so as to form a flow channel for a liquid coolant between them, wherein said flow channel defines a high-resistance flow channel being flat and uniform in thickness thereof, and further comprises a buffer portion on one of upstream side and downstream side of said high-resistance flow channel.

And, according to the present invention, there is further provided a liquid crystal panel for use in a liquid crystal projector, comprising: two (2) pieces of transparent substrates, enclosing a liquid crystal between them; and further at lease a transparent plate, being disposed opposing to one surface of said two (2) pieces of transparent substrates, so as to form a flow channel for a liquid coolant between them, wherein said flow channel defines a high-resistance flow channel being flat and uniform in thickness thereof, and further comprises an auxiliary flow channel lower in flow resistance than said high-resistance flow channel, being formed on a periphery of said high-resistance flow channel.

Further, according to the present invention, also for accomplishing the object mentioned above, there may be provided a liquid cooling apparatus for cooling liquid crystal panels for use in a liquid crystal projector, each panel having two (2) pieces of transparent substrates, enclosing a liquid crystal between them, with a liquid coolant, comprising: at least a transparent plate, being disposed opposing to one surface of said two (2) pieces of transparent substrates, so as to define therebetween a high-resistance flow channel being flat and uniform in thickness thereof, covering a liquid crystal panel area of said liquid crystal panel, and also a buffer portion neighboring to said flow channel; further a driving means for the liquid coolant, connected to said buffer portion of said liquid crystal panel; and a heat radiator means for radiating heat of said liquid crystal panel, which is received in said flow channel into an outside, whereby building a liquid cooling cycle.

Also, according to the present invention, there may be provided a liquid cooling apparatus for cooling liquid crystal panels for use in a liquid crystal projector, each panel having two (2) pieces of transparent substrates, enclosing a liquid crystal between them, with a liquid coolant, comprising: at least a transparent plate, being disposed opposing to one surface of said two (2) pieces of transparent substrates, so as to define therebetween a high-resistance flow channel being flat and uniform in thickness thereof, covering a liquid crystal panel area of said liquid crystal panel, and also an auxiliary flow channel lower in flow resistance than said high-resistance flow channel, being formed surrounding said flow channel; further a driving means for the liquid coolant, connected to said buffer portion of said liquid crystal panel; and a heat radiator means for radiating heat of said liquid crystal panel, which is received in said flow channel into an outside, whereby building a liquid cooling cycle.

In addition to the above, the present specification also mentions a liquid crystal projector, comprising: a light source; an optical element for changing the light from said light source into a parallel light, to be divided into three (3) light beams; three (3) kinds of liquid crystal panels for transmitting the three (3) light beams divided by said optical element therethrough, so as to modulate intensity thereof; an optical synthesizing means for synthesizing the three (3) light beams, passing through said three (3) kinds of liquid crystal panels, to be modulate intensity thereof; a projection means for projecting the three (3) light beams, which are synthesized by said optical synthesizing means; and a liquid cooling cycle, including a pump and a radiator therein, for circulating a liquid coolant within said three (3) kinds of liquid crystal panels, so as to conduct cooling thereof, wherein each of said three (3) kinds of liquid crystal panels defines a flow channel for the liquid coolant between a surface of said liquid crystal panel and a transparent member to be disposed opposing thereto, respectively, and further, said flow channel includes a first flow channel being flat and uniform in thickness thereof, covering a liquid crystal panel area of said liquid crystal panel, and also a second flow channel provided on a one of upstream side and downstream side of said first flow channel, having flow resistance higher than that in said first flow channel.

The present specification also mentions a liquid crystal panel for use in a liquid crystal projector, comprising: two (2) pieces of transparent substrates, enclosing a liquid crystal between them; and further at lease a transparent plate, being disposed opposing to one surface of said two (2) pieces of transparent substrates, so as to form a flow channel for a liquid coolant between them, wherein said flow channel defines a first flow channel being flat and uniform in thickness thereof, within an area covering a liquid crystal area of said liquid crystal panel, and further comprises a second flow channel neighboring to a one of upstream side and downstream side of said high-resistance flow channel, having flow resistance higher than that in said first flow channel.

Further, the present specification also mentions, a liquid cooling apparatus for cooling liquid crystal panels for use in a liquid crystal projector, each panel having two (2) pieces of transparent substrates, enclosing a liquid crystal between them, with a liquid coolant, comprising: at least a transparent plate, being disposed opposing to one surface of said two (2) pieces of transparent substrates, so as to define therebetween a first flow channel being flat and uniform in thickness thereof, covering a liquid crystal panel area of said liquid crystal panel, and also a second flow channel on a one of upstream side and downstream side of said first flow channel, being higher in flow resistance than that in said first flow channel; further a driving means for the liquid coolant, connected to said first and said second flow channels of said liquid crystal panel; and a heat radiator means for radiating heat of said liquid crystal panel, which is received in said first and said second flow channels into an outside, whereby building a liquid cooling cycle.

However, according to the present invention, in the liquid crystal projector, the liquid crystal panel for use in a liquid crystal projector, and the liquid cooling apparatus for cooling liquid crystal panels for use in a liquid crystal projector, as described in the above, preferably, said liquid crystal panel further comprises a buffer portion neighboring to said second flow channel, in addition to said second flow channel.

### BRIEF DESCRIPTION OF DRAWINGS

Figs. 1(a) and 1(b) are cross-section views, including A-A cross section thereof, for showing the details of interior structures of a liquid crystal panel for use in a liquid crystal projector, according to an embodiment 1 of the present invention;
Fig. 2 is a view for explaining a circulation flow of a liquid coolant within the liquid crystal projector, according to the embodiment 1 of the present invention;
Fig. 3 is a block diagram for showing an example of the entire structures of the liquid crystal projector, having liquid cooling apparatus for the liquid crystal panels, according to the present invention;
Figs. 4(a) and 4(b) are cross-section views, including A-A cross section thereof, for showing the details of interior structures of a modification of the liquid crystal panel, which is shown in Figs. 1(a) and 1(b);
Figs. 5(a) and 5(b) are further cross-section views, including A-A cross section thereof, for showing the details of interior structures of the liquid crystal panel, according to other modification of the present invention;
Figs. 6 (a) to 6(c) are cross-section views, including A-A and B-B cross sections thereof, for showing the details of the interior structures of the liquid crystal panel, according to other modification of the present invention;
Fig. 7 is a cross-section view for showing a modification of the liquid crystal panel, according to the other embodiment, which is shown in Figs. 6(a) to 6(c) mentioned above;
Figs. 8 (a) and 8(b) are cross-section views, including A-A cross section thereof, for showing the details of interior structures of a modification of a liquid crystal panel for use in a liquid crystal projector, according to an embodiment 2 of the present invention;
Fig. 9 is a view for explaining a circulation flow of a liquid coolant within the liquid crystal projector, according to the embodiment 2 of the present invention;
Figs. 10(a) and 10 (b) are cross-section views, including A-A cross section thereof, for showing the details of interior structures of a modification of the liquid crystal panel, which is shown in Figs. 8(a) and 8(b);
Fig. 11 is a cross-section view for showing the details of interior structures of the liquid crystal panel, according to a modification of the present invention motioned above;
Fig. 12 is a cross-section view for showing the details of interior structures of the liquid crystal panel, according to other modification of the present invention motioned above;
Fig. 13 is a cross-section view for showing the details of interior structures of the liquid crystal panel, according to further other modification of the present invention motioned above; and
Fig. 14 is a cross-section view for showing the details of interior structures of the liquid crystal panel, according to further other modification of the present invention motioned above.

### BEST MODE FOR CARRYING OUT THE INVENTION

Hereinafter, embodiments according to the present invention will be fully explained by referring to the attached drawings.

### Embodiment 1

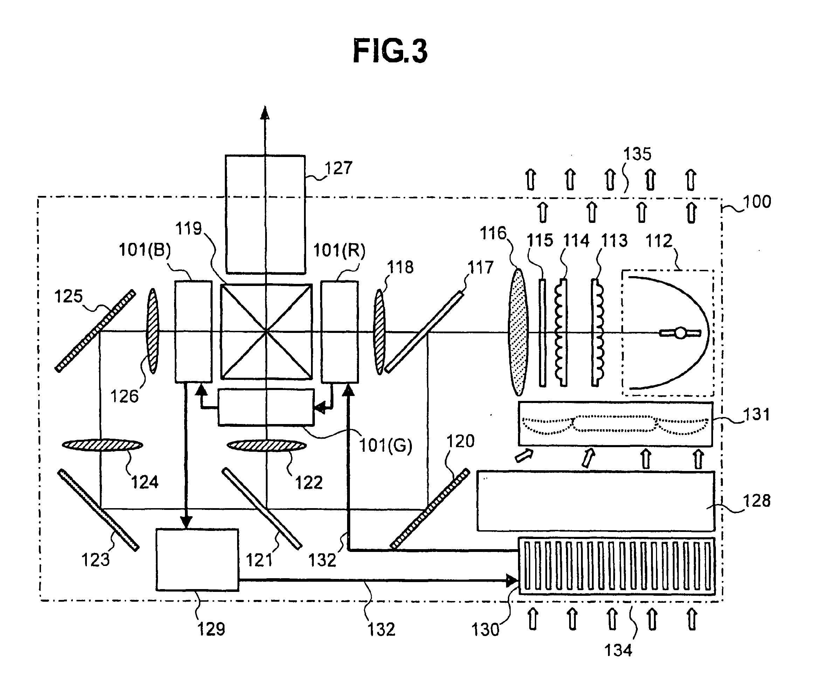

First of all, Fig. 3 shows an example of the entire structures of a liquid crystal projector, comprising a liquid cooling apparatus for liquid crystal panels therein, according to an embodiment of the present invention. In the figure, a reference numeral 100 depicts a housing of the liquid crystal projector, and also, as is apparent from the figure, within an inside thereof is provided a light irradiation source, such as, a metal halide lamp 112, for example. And, the lights from the light irradiation source 112 are brought into a parallel light by the functions of a first lens array 113, a second lens array 114, a polarization converter element 115 and a condensing lens 116, to be outputted. This parallel light, thereafter, is guided onto a first dichroic mirror 117, and a part thereof, while penetrating through it, is guided onto a liquid crystal panel 101(R) for use of R (red) through a first condenser lens 118, to be modulated therein, and thereafter it reaches to a photosynthesizing prism 119.

On the other hand, the light reflected upon the first dichroic mirror 117 mentioned above, is reflected upon the surface of a first reflection mirror 120, to be incident upon a second dichroic mirror 121. The light reflected thereon is guided onto a liquid crystal panel 101 (G) for use of G (green) through a second condenser lens 122, and after being modulated therein it reaches to the photosynthesizing prism 119. Further, the light penetrating through the second dichroic mirror 121, passing through a second reflection mirror 123 and a relay lens 124, is reflected upon the surface of a third reflection mirror 125, and is guided onto a liquid crystal panel 101(B) for use of B (Blue) through a third condenser lens 126, to be modulated therein; thereby reaching to the photosynthesizing prism 119 mentioned above. And, the lights, the light intensity of which are modulated in those liquid crystal panels 101(R), 101(G) and 101(B) for the three (3) fundamental colors, respectively, are synthesized by means of the photosynthesizing prism 119 mentioned above, and are further extended through a projection optic system 127, including a projection lens therein, for example; thereby being projected on a screen not shown in the figure, for example (see a thin arrow in the figure).

Also, a reference numeral 131 in the figure depicts a cooling fan unit, including a fan and a motor for rotationally driving thereof within an inside thereof, for example, wherein an outside air is taken into the housing through an air suction opening 134, which is formed in a part of the housing 100 of the liquid crystal projector motioned above, as is shown by outlined arrows in the figure, so as to cool down an electric parts unit 128 for electrically controlling/driving various parts, including the liquid crystal panels for R, G and B, therein, for example, as well as, a heat radiating unit 130, which will be mentioned later. Further, the air taken into is discharged, after cooling down the metal halide lamp 112, such as a high luminous light irradiation source, being at issue due to the reason of heat generation, because of a remarkable demand for a high intension of illumination accompanying with the large-sizing of a display screen in recent years, as was mentioned above, and further the first lens array 113, the second lens array 114, the polarization converter element 115, and the condensing lens 116, which are disposed in the vicinity of that light irradiation source, into an outside through an air discharge opening 135, which is formed in a part of the housing 100.

And, within each of the liquid crystal panels 101(R), 101(G) and 101(B) for the three (3) fundamental colors, R, G and B, there is formed a passage for a liquid coolant, respectively, although the details of which will be mentioned later, and a liquid coolant is circulated by the function of an electromotive pump 129 having a tank in a part thereof, which is provided in an inside of the housing 100 of the liquid crystal projector mentioned above, as is indicted by thick black arrows in the figure, through pipes provided around within the housing, in the order, i.e., the liquid crystal panels 101(R), 101(G) and 101(B) for R, G and B, the electromotive pump 129, and the heat radiating unit 130; thereby building up so-called a liquid cooling cycle.

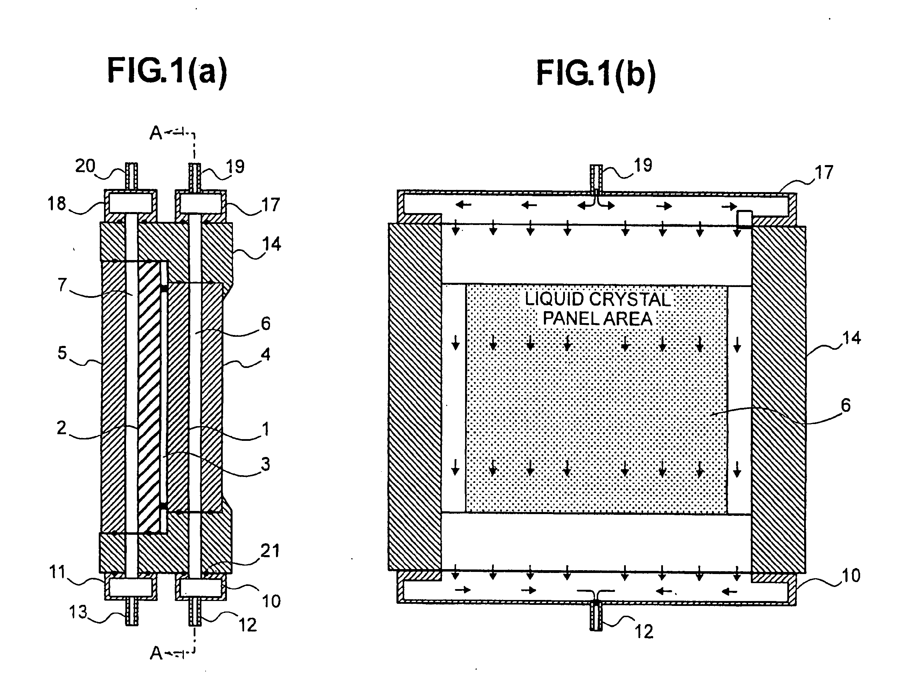

Next, in Figs. 1(a) and 1(b) attached herewith are shown the liquid crystal panels 101(R), 101(G) and 101(B) for R, G and B, in particular, the details of interior structures of one of those. First of all, in Fig. 1(a) for showing the cross-section view of the liquid crystal panels 101, a reference numeral 2 depicts a TFT substrate made of a glass, for example, on the surface of which a large number of transistor driver elements are formed, building up a main constituent element of that liquid crystal panel 101, while an opposite substrate 1 also made of glass is disposed opposing to that liquid crystal panel 101, and a liquid crystal 3 is sealed or enclosed between those transparent substrates 2 and 1; thereby building up one (1) of the liquid crystal panels 101 for the three (3) fundamental colors, R, G and B.

Also, reference numerals 4 and 5 in the figure are so-called the protection glasses, and those protection glasses are provided on a light incident side and a light emission side of the liquid crystal panel 101, and between them are formed flow channels 6 and 7 having high resistance for the liquid coolant. Surrounding the periphery of the opposite substrate 1, the TFT substrate 2 and the protection glass plates 4 and 5, there is attached a case 14 for making up a frame body, and in edge portions at top and bottom thereof are also formed the flow channels 6 and 7 of high resistance for the liquid coolant, neighboring to each other, continuously, in a slit-like manner, and having width same to that of the flow channel mentioned above (i.e., in the horizontal direction in Fig. 1(b)). And, at the upper edge portion and the lower edge portion of this case 14 are attached box-like members 10 and 11 (lower) and 17 and 18 (upper), respectively, for making up buffer flow channels. Thus, as is apparent from Fig. 1(b) showing the A-A cross-section view in Fig. 1(a) mentioned above, on both side surfaces of the panel, including an area or region where the above-mentioned liquid crystal 101 is formed (hereinafter, being called by "a liquid crystal panel area (or region)" therein, the flat flow channels 6 and 7 of high resistance are formed, respectively; i.e., between the opposite substrate 1 and the protection glass plate 4, and between the TFT substrate 2 and the protection glass plate 5, and being equal in thickness "d" (i.e., the height in direction perpendicular to the paper surface of Fig. 1(b)). Further, though not shown in the figure herein, but on the light incident side surface and the light emission side surface of the protection glass plates 4 and 5 are formed polarizing films, respectively.

However, in this Fig. 1(b) are shown the flows of the liquid coolant in the flow channels, which are formed within an inside of the liquid crystal panel 101, with an aid of arrows. Also, reference numerals 12, 13, 19 and 20 in those Figs. 1(a) and 1(b) depict induction/delivery tubes for the liquid coolant, each being attached around a central portion of the box-like members 10 and 11 (lower) and 17 and 18 (upper), respectively, which are provided for building up the buffer channels mentioned above. Also, a portion painted with a black color, which is represented by a reference numeral 21 in the figure, for example, depicts so-called "O" rings, which are inserted between the members mentioned above for hermetically sealing up between themwhen assembling those members.

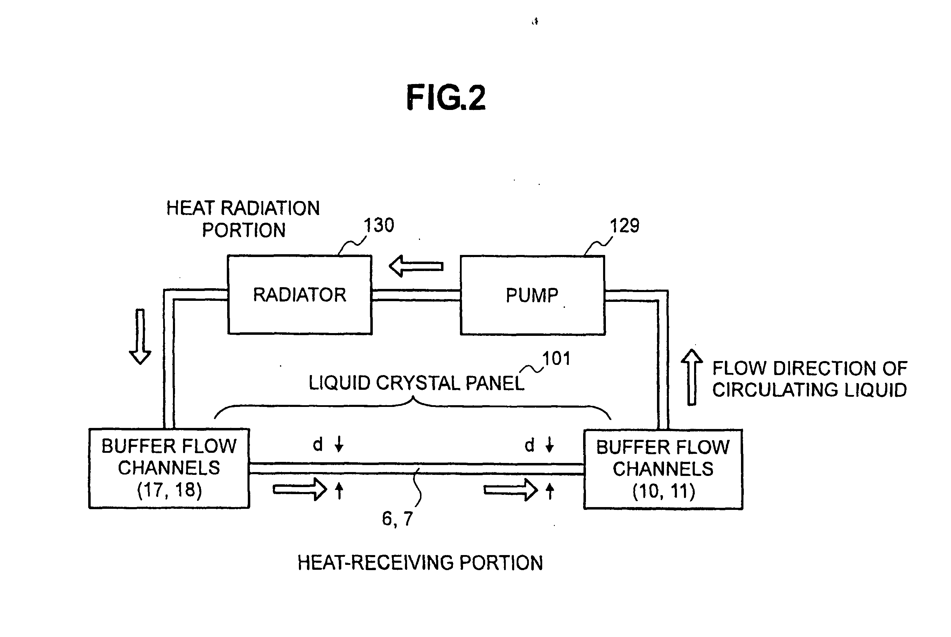

Next, explanation will be made in details about the circulating flow of the liquid coolant in the liquid crystal projector, according to the present invention, including the respective liquid crystal panels 101 in apart thereof, the detailed structures of which are shown in the above, by referring to Fig. 2. However, herein the explanation was made that the liquid crystal panels 101(R), 101(G) and 101(B) for R, G and B are connected in series within the liquid cooling cycle shown in the figures, in which the liquid coolant is driven with the function of the pump 129, to be circulated through the radiator 130 for building up the heat radiation portion thereof. But, according to the present invention, it should not be restricted only to that, and those liquid crystal panels 101(R), 101(G) and 101(B) may be connected in parallel with, within the liquid cooling cycle mentioned above. Then, in this figure, the explanation will be made only by taking out one (1) of those three (3) kinds thereof, i.e., to be a single liquid crystal panel 101.

Namely, receiving heat within the liquid crystal panel 101, heated upon receipt of the lights from the light irradiation source 112, being strong in the intensity thereof, the liquid coolant increased in temperature thereof is discharged from the buffer flow channels 10 and 11, to be driven by the pump 129, and it passes through the radiator 130. In that instance, the heat is discharged into an outside, thereby to be cooled down, and then the liquid coolant flows into the buffer flow channels 17 and 18, again, which are attached on both the top and bottom edge portions of the case 14, being the frame body of the liquid crystal panel 101 mentioned above. Thereafter, the liquid coolant within the buffer flow channels 17 and 18 passes through, within the case 14 mentioned above and also the flat flow channels 6 and 7 of high resistance, having the thickness "d", which are formed between the opposite substrate 1 and the protection glass plate 4 and between the TFT substrate 2 and the protection glass plate 5, and again, it reaches to the buffer flow channels 10 and 11, which are formed on the lower edge portion of the case 14. And, the liquid coolant receives the heat from the liquid crystal panel 101 that is heated by the lights of high intensity from the light source mentioned above, when it passes through the flat flow channels 6 and 7 of high resistance, having the thickness "d", in particular, the liquid crystal panel area thereof, and thereafter, it circulates within the cycle mentioned above by the function of the pump 129 mentioned above, again.

With such structures of the flow channels, the liquid coolant expands into the width direction (i.e., in the horizontal direction in Fig. 1(b)), to be greatly reduced in the flow velocity thereof, within the buffer flow channels 17 and 18 (upper) and 10 and 11 (lower); i.e., being equal in the pressure within the buffer flow channels. When it is so, since a flow rate (i.e., the flow velocity) of the liquid coolant, flowing within the flat flow channels 6 and 7 of high resistance having the thickness "d", which are formed in the liquid crystal panel area, is proportional to the differences in the pressure and the cross-section areas between the upper buffer flow channel and the lower buffer flow channel, therefore the flow velocity within the flow channels 6 and 7 of high resistance comes to be constant if the thickness "d" of the high resistance flow channels 6 and 7 is equal or uniform in the width direction thereof.

In this manner, with such structures of the flow channels mentioned above, it is possible to prevent the liquid coolant from generating eddy and/or drifting within an area of the liquid crystal panel surface, while achieving an increase of the velocity of coolant flowing on the surface of the liquid crystal panel (i.e., the liquid crystal panel area) and equalization (or, making uniform) thereof. Also, for that reason, there is no chance of generating difference in density of the coolant flowing within an inside thereof, or generating difference in the cooling capacity, and therefore, no distribution is created in temperature on the surface of the liquid crystal panel, nor no difference in the refractive index because of that. For the reason, no disturbance is generated on the picture obtained, such as the fluctuation, etc., and thereby enabling an improvement in the quality of the picture. In addition thereto, with such the flow channel structures as mentioned above, since the so-called liquid cooling cycle can be established, wherein the heat generated is discharged into an outside through the radiator 130 making up the heat radiation portion, while driving the liquid coolant by means of the pump 129, it is needless to say that the liquid crystal panel can be cooled down at higher cooling efficiency.

Although it is explained that the buffer flow channels 17 and 18 (upper) and 10 and 11 (lower) are provided, respectively, on both sides of the float flow channels of high resistance, having the thickness "d" mentioned above, e.g., at top and bottom thereof, in the explanation made in the above, however the present invention should not be restricted only to such the structures mentioned above, and therefore, only one of those may be provided on the upstream side or the downstream side thereof.

In addition to the above, as the liquid coolant flowing in each of the flow channels mentioned above can be applied, for example, a water mixing an antifreezing solution, such as, ethylene glycol and/or propylene glycol, for example, in a part thereof, or alternatively, an inactive liquid of fluorine (par-chlorocarbon), such as, fluorinate (the trade mark of Sumitomo-3M company) representatively, for example, being superior in light permeability, inactive, and less in bubbling, and having electrical insulating property, as well. In particular, with application of the liquid coolant of the latter, it is possible to protect the projection picture from deterioration or degradation thereof, due to mixing of bubbles into the liquid coolant flowing in the flow channels within the liquid crystal panel area mentioned above, effectively. Also, in particular, upon the surface of the various substrates, building up the flat and high-resistance flow channels 6 and 7 having the thickness "d", within the liquid crystal panel area, it is preferable to treat a process for maintaining hydrophilic nature or property thereof, such as, coating of a thin film of titan oxide, for example. With this, due to the function of photocalytic reaction of the titan oxide with the lights from the lamp mentioned above, the wall surfaces thereof can be kept to be hydrophilic, always; therefore, it is possible to restrain dusts and bubbles from adhering upon the said wall surface.

Further, it is preferable that the flat flow channels 6 and 7 of high resistance be determined about from 0.2mm to 5mm in the thickness "d" thereof, for example, and that the flow velocity of the liquid coolant within an inside thereof be determined so that it comes up to be equal about 10 times of an averaged flow velocity within the buffer flow channels 17 and 18 (upper) and 10 and 11 (lower), or higher than that.

Also, in the embodiment mentioned above, explanation was made that the flat high-resistance flow channels 6 and 7, which are formed on both sides (e.g., the light incident side and the light emission side) of the liquid crystal panel 101, are equal to each other in the thickness "d" thereof. However, it is also possible to make the thickness "d" different from each other, thereby to change the flow velocity (e.g., the flow rate) of the liquid coolant within an inside thereof, for example, in a case when the heat generation on the light incident side surface of the liquid crystal panel 101 is lager than that on the light emission side, etc.

As was mentioned above, with the high and uniform velocity of the coolant flowing through the liquid crystal panel, covering over the entire thereof, it is possible to obtain a good or preferable picture quality, without generating the fluctuations, etc., on the picture obtained therefrom, and also building up the liquid cooling system of discharging the heat generated inside the liquid crystal panel into an outside, actively, enables to cool down the liquid crystal panel at higher cooling efficiency. And, with the liquid crystal projector, applying such the liquid crystal panels 101 into the liquid crystal panels 101(R), 101(G) and 101(B) for use of R, G and B, it is possible to maintain a lifetime and reliability for those liquid crystal panels, in spite of an increase in an amount or volume of heat generation on the liquid crystal panels, accompanying with the small-sizing, silent operation, and high luminance or brightness thereof.

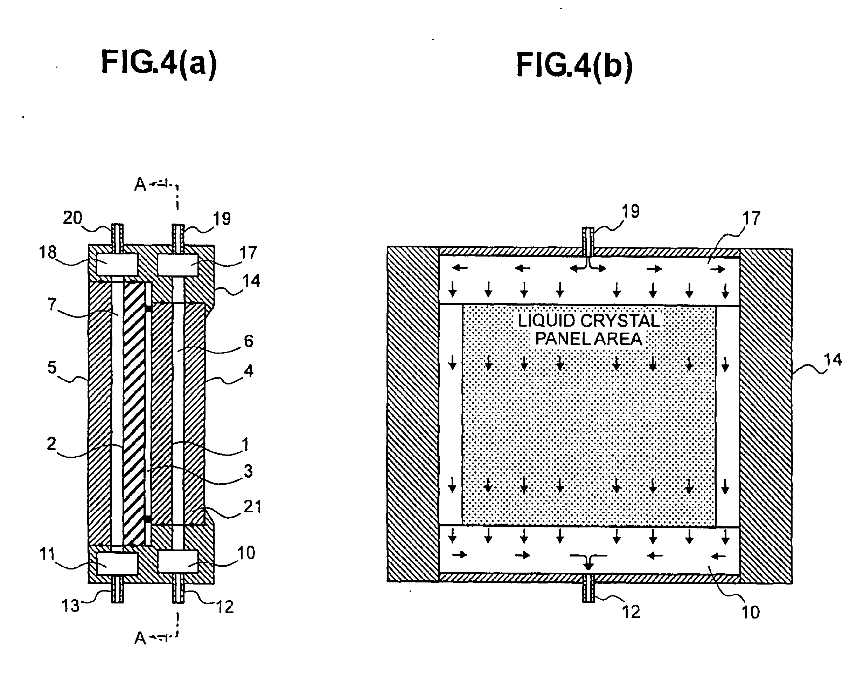

Next, Fig. 4 (a) attached herewith shows a modification of the liquid crystal panel 101 shown in Figs. 1 (a) and 1 (b), by the cross-section view thereof, and also Fig. 4(b) shows the A-A cross-section view in Fig. 4(a) mentioned above. With the liquid crystal panel 101 according to this modification, in the places of the box-like members 10 and 11 (lower) and 17 and 18 (upper) for building up the buffer flow channels shown in Figs. 1(a) and 1(b), those buffer flow channels 10 and 11 (lower) and 17 and 18 (upper) are formed within the top and bottom edge portions the case 14 mentioned above. Further, with the structures of the liquid crystal panel 101 according to such the modification, in addition to the effects similar to those obtainable from the liquid crystal panel according to the above-mentioned embodiment, it is also possible to reduce the number of parts building up the liquid crystal panels, thereby achieving a low cost thereof, in particular, through forming the buffer flow channels within the case 14, and also reducing the outer sizes thereof, much more.

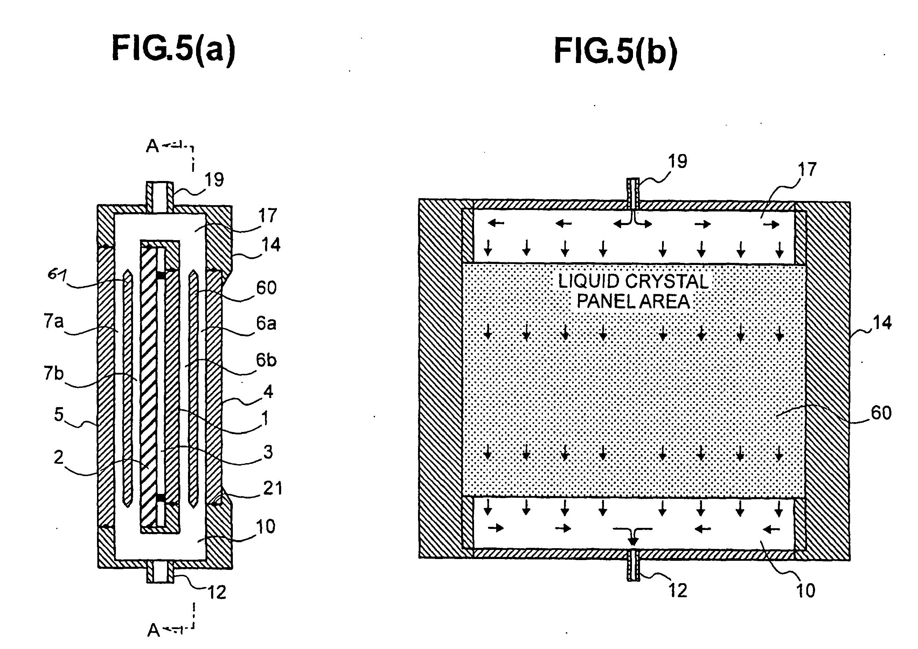

Next, Figs. 5(a) and 5(b) attached herewith show the cross-section views of the liquid crystal panel 101, according to other modification, further. With the liquid crystal panel 101 according to the other variation, as is apparent from the figures, within the flow paths being defined between the opposite substrate 1 and the protection glass plate 4 and also between the TFT substrate 2 and the protection glass plate 5, there are inserted separation plates 60 and 61, respectively, each being a flat and transparent plate-like member having a uniform thickness; thereby defining the flow channels 6a and 6b, and 7a and 7b, of high resistance, within the liquid crystal panel area, and as the same time, the buffer flow channels 10 and 17 are formed, respectively, within the tip and bottom edge portions of the case 14 to be unified therewith. However, with such the structures, by changing the thickness of the separation plates 60 and 61 mentioned above, it is possible tovaryoradjust the flowresistance of the flow channels 6a and 6b, and 7a and 7b, of high resistance, appropriately, and also possible to form the high-resistance flow channels, easily. Also, similar to that mentioned above, it is possible to reduce the number of parts building up the liquid crystal panels, thereby achieving a low cost thereof, in particular, through forming the buffer flow channels within the case 14, and also reducing the outer sizes thereof, much more.

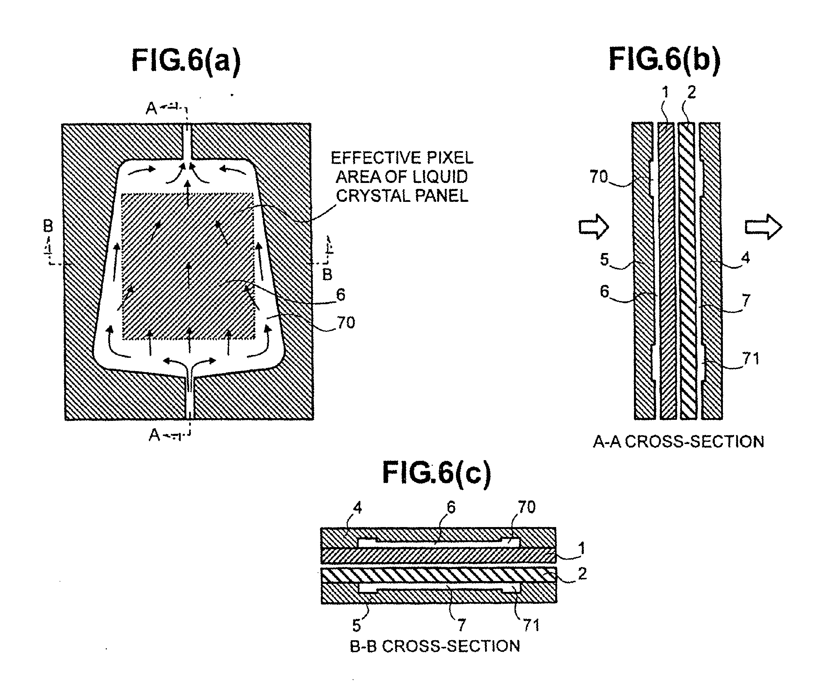

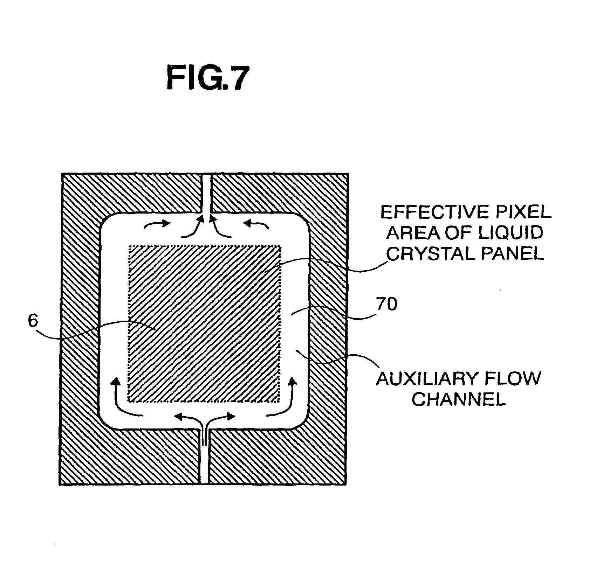

Next, Figs. 6(a) to 6(c) and Figs. 7(a) and 7(b) attached herewith show the detailed structures of the liquid crystal panel for use of the liquid crystal projector, according to other embodiment of the present invention.

First of all, Fig. 6 (a) shows the plane cross-section view of the liquid crystal panel, according to the other embodiment, and also Figs. 6(b) and 6(c) show the A-A cross-section view and the B-B cross-section view in Fig. 6(a). However, in those figures, the constituent elements similar or same to those, which are illustrated in the above, are also attached with the same reference numerals thereof.

As is apparent from those figures, within the liquid crystal panel according to this other embodiment, corresponding to the above-mentioned liquid crystal panel area , i.e., an effective pixel area of the liquid crystal panel, there are also defined the high-resistance flow channels 6 and 7, each having a small thickness "d", between the opposite substrate 1 and the protection glass plate 4, and between the TFT substrate 2 and the protection glass plate 5, building up the liquid crystal panel, respectively, and in the places of the buffer potions mentioned above, in particular, as is apparent from Fig. 6(a), auxiliary flow channels 70 and 71 of low resistance, having thickness larger than the thickness "d" of the high-resistance flow channel, are formed around the periphery of the high-resistance flow channels 6 and 7 mentioned above. Also, with the liquid crystal panel according to this other embodiment, also apparent from Fig. 6(a), the auxiliary flow channels 70 or 71 is formed to be wide in width below (i.e., the upstream side of the liquid coolant), and thereafter, to be narrow in width, gradually, as it moves upwards in the figure (i.e., the downstream side of the liquid coolant).

Namely, with the liquid crystal panel according to the other embodiment, the structures of which was explained in the above, it is also possible to achieve the high and uniform velocity of the coolant flowing through the liquid crystal panel, covering over the entire of effective pixel area thereof (i.e., the liquid crystal panel area), within the liquid crystal panel, and with this it is possible to obtain a good or preferable picture quality, without generating the fluctuations, etc., on the picture obtained therefrom. In addition thereto, because of building up the liquid cooling system of discharging the heat generated inside the liquid crystal panel into an outside, actively, it is possible to cool down the liquid crystal panel at higher cooling efficiency, and at the same time, with forming the auxiliary flow channels of low resistance surrounding the periphery of the high-resistance flow channels, in the places of the buffer portions, it is possible to bring the coolant flowing within the high-resistance flow channels, uniformly, from the periphery thereof, as is shown by arrows in Fig. 6(a). Also, since this structure necessitates no forming of the buffer portions or the like within the inside thereof, nor the case surrounding the periphery of the various substrates building up the liquid crystal panel, it is possible to reduce the number of parts building up the liquid crystal panels, thereby achieving a low cost thereof, and also to reduce the outer sizes thereof, much more; therefore, being advantageous.

Further, Fig. 7 attached herewith shows a variation of the liquid crystal panel according to the other embodiment explained in the above, by a plane cross-section view thereof. However, in this variation, as is apparent from the figure, the auxiliary flow channel 70 or 71 of low resistance shown in Figs. 6(a) to 6(c)
is modified into an auxiliary flow channel 70 (or 71), which is rectangular in an outer shape thereof, surrounding the periphery of the rectangular high-resistance flow channel 6 (or 7), which is formed corresponding to the effective pixel region (i.e., the liquid crystal panel area) of the liquid crystal panel, with a uniform width. However, with this variation, it is also possible to bring the coolant flowing within the high-resistance flow channel 6, uniformly, from the periphery thereof, in the similar manner to the above, and also since it needs no such case mentioned above, it is possible achieve an effect of reducing the number of the constituent parts thereof, and further that of reducing the outer sizes thereof, much more.

### Embodiment 2

Next, explanation will be made on the embodiment 2, according to the present invention, by referring to drawings attached herewith. However, in this embodiment2, the constituent elements common to those, which are illustrated in the above embodiment 1, are also attached with the same reference numerals thereof.

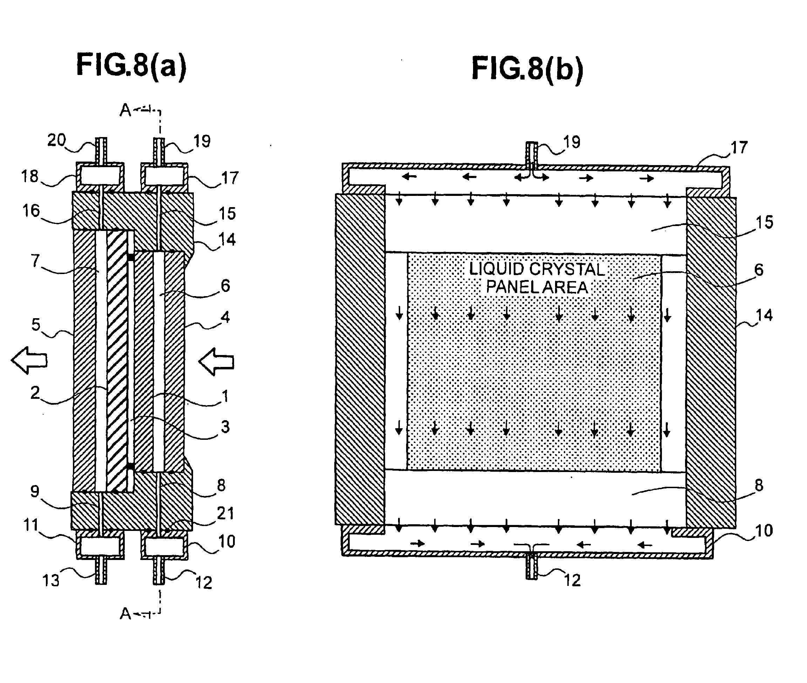

Figs. 8(a) and 8(b) show the detailed interior structures of the liquid crystal panel 101, representatively, one of those liquid crystal panels 101(R), 101(G) and 101(B) for R, G and B mentioned above. Firstly, in Fig. 8(a) showing the cross-section of the liquid crystal panel 101, a reference numeral 2 depicts a TFT substrate made of a glass, for example, on the surface of which a large number of transistor driver elements are formed, building up a main constituent element of that liquid crystal panel 101, while an opposite substrate 1 also made of glass is disposed opposing to that liquid crystal panel 101, and a liquid crystal 3 is sealed or enclosed between those transparent substrates 2 and 1; thereby building up one (1) of the liquid crystal panels 101 for the three (3) fundamental colors, R, G and B.

Also, reference numerals 4 and 5 in the figure are so-called the protection glasses, and those protection glasses are provided on a light incident side and a light emission side of the liquid crystal panel 101, and between them are formed flow channels 6 and 7 having high resistance for the liquid coolant. Surrounding the periphery of the opposite substrate 1, the TFT substrate 2 and the protection glass plates 4 and 5, there is attached a case 14 for making up a frame body. Thus, as is apparent from Fig. 8(b) showing the A-A cross-section view in Fig. 8(a) mentioned above, on both side surfaces of the panel, including an area or region where the above-mentioned liquid crystal 101 is formed (hereinafter, being called by "a liquid crystal panel area (or region) " therein, the flat flow channels 6 and 7 of high resistance are formed, respectively; i.e., between the opposite substrate 1 and the protection glass plate 4, and between the TFT substrate 2 and the protection glass plate 5, and being equal in thickness "D" (i.e., the height in direction perpendicular to the paper surface of Fig. 8(b)). Further, though not shown in the figure herein, but on the light incident side surface and the light emission side surface of the protection glass plates 4 and 5 are formed polarizing films, respectively.

And, in the edge portions at top and bottom of the case 14 building up the frame, which is formed to surround the various substrates mentioned above, as is apparent from Fig. 8(a), there are formed flow channels 8 and 9 (lower) and 15 and 16 (upper) in a slit-like manner, having thickness "d" smaller than the thickness "D" of the flow channels 6 and 7 (i.e., d<D), and as is apparent from Fig. 8 (b), are formed with the width (i.e., the horizontal direction in Fig. 8(b)) being same to that of the flow channels mentioned above, respectively. Further, at end surfaces of the top and bottom edge portions of the case 14 are attached the box-like member 10 and 11 (lower) and 17 and 18 (upper) for forming the buffer flow channels therein, respectively. Further, in this Fig. 8(b), the flows of the liquid coolant are shown by arrows, within the flow channels formed within an inside of the liquid crystal panel 101. Also, reference numerals 12, 13, 19 and 20 in those Figs. 1(a) and 1(b) depict induction/delivery tubes for the liquid coolant, each being attached around a central portion of the box-like members 10 and 11 (lower) and 17 and 18 (upper), respectively, which are provided for building up the buffer channels mentioned above. Also, a portion painted with a black color, which is represented by a reference numeral 21 in the figure, for example, depicts so-called "O" rings, which are inserted between the members mentioned above for hermetically sealing up between them when assembling those members.

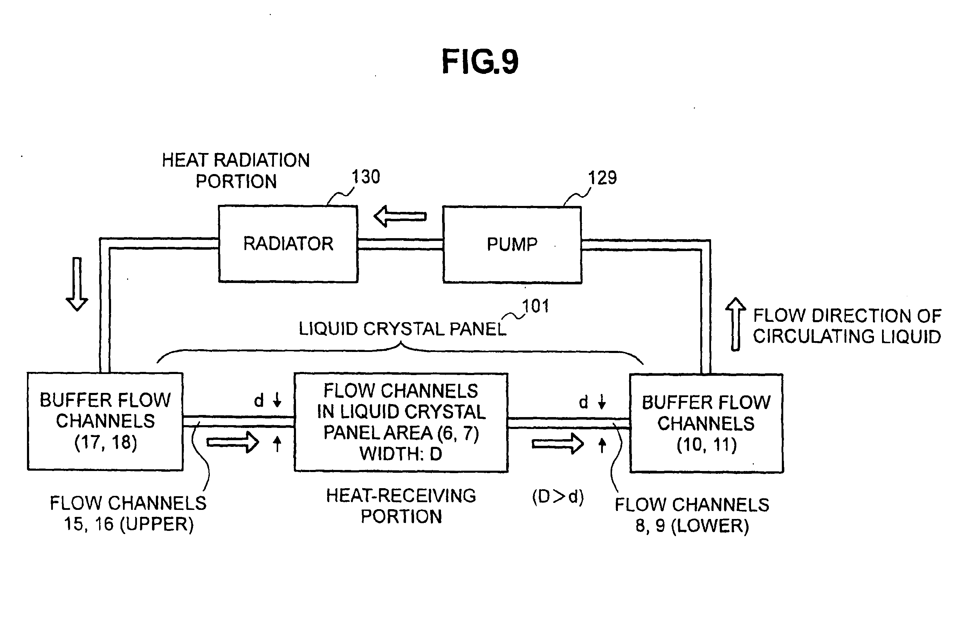

Next, explanation will be made in details about the circulating flow of the liquid coolant in the liquid crystal projector, according to the second embodiment of the present invention, including the respective liquid crystal panels 101 in a part thereof, the detailed structures of which are shown in the above, by referring to Fig. 9. However, herein the explanation was made that the liquid crystal panels 101(R), 101(G) and 101(B) for R, G and B are connected in series within the liquid cooling cycle shown in the figures, in which the liquid coolant is driven with the function of the pump 129, to be circulated through the radiator 130 for building up the heat radiation portion thereof. But, according to the present invention, it should not be restricted only to that, and those liquid crystal panels 101(R), 101(G) and 101(B) may be connected in parallel with, within the liquid cooling cycle mentioned above. Then, in this figure, the explanation will be made only by taking out one (1) of those three (3) kinds thereof, i.e., to be a single liquid crystal panel 101.

Namely, receiving heat within the liquid crystal panel 101, heated upon receipt of the lights from the light irradiation source 112, being strong in the intensity thereof, the liquid coolant increased in temperature thereof is discharged from the buffer flow channels 10 and 11, to be driven by the pump 129, and it passes through the radiator 130. In that instance, the heat is discharged into an outside, thereby to be cooled down, and then the liquid coolant flows into the buffer flow channels 17 and 18, again, which are attached on top and bottom edge portions of the case 14, being the frame body of the liquid crystal panel 101 mentioned above. Thereafter, the liquid coolant within the buffer flow channels 17 and 18, after passing through the flat flow channels 15 and 16 having the thickness "d", which are formed in the upper edge portion of the case 14, then thereafter through the flat flow channels 6 and 7 having the thickness "D" of the liquid crystal area, and further passing through the flat flow channels 10 and 11 having the thickness "d", which are formed in the lower edge portion of the case 14, turns back to the buffer flow channels 10 and 11 mentioned above, again. In that instance, as was mentioned above, on both sides (up and down) of the flat flow channels 6 and 7 of the liquid crystal panel area are provided so-called, the high-resistance flow channels, i.e., the flat flow channels 15 and 16 (upper) and 10 and 11 (lower), having the thickness "d" (D>d).

Thus, with such structures of the flow channels, the liquid coolant flowing therein from the induction tube 20 for the liquid coolant, for example, expands into the width direction (i.e., in the horizontal direction in Fig. 8(b)), to be greatly reduced in the flow velocity thereof, because of provision of the flat flow channel 16 having the thickness "d" for building up the high-resistance flow channel. As a result thereof, the pressure comes to be equal or uniform within the buffer flow chamber 18. Further, since the buffer flow channel 11 is also provided in the downstream side of the flat flow channels 7 the thickness "D", covering the liquid crystal panel area, continuing with the flat flow channel 9 of high resistance, therefore the pressure within the buffer flow channel 11 comes to be equal or uniform even if sucking the coolant from a piece of the delivery tube 13, due to largeness of the flow resistance within the flow channel 9. When it is so, since a flow rate (i.e., the flow velocity) of the liquid coolant, flowing within the flat flow channels 16 and 17 of high resistance and the flat flow channel 7 having the thickness "D", is proportional to the differences in the pressure and the cross-section area between the upper buffer flow channel and the lower buffer flow channel, therefore the flow velocity within the flow channel 7 comes to be constant if the thickness "D" of the flow channel 7 and the thickness "d" of the flow channels 16 and 9 are equal or uniform in the width direction thereof. In the similar manner, the liquid coolant flowing therein from the induction tube 19 for liquid coolant flows at an equal or uniform velocity in the flat flow channel 6 having the thickness "D".

In this manner, with such structures of the flow channels mentioned above, it is possible to prevent the liquid coolant from generating eddy and/or drifting within an area of the liquid crystal panel surface (i.e., the liquid crystal panel area), with equalization and stabilization of the coolant flowing therein. Also, for that reason, there is no chance of generating difference in density of the coolant flowing within an inside thereof, or generating difference in the cooling capacity; i.e., no distribution is created in temperature on the surface of the liquid crystal panel, nor no difference in the refractive index due to that. For the reason, no drawback is generated on the picture obtained, such as the fluctuation, discoloring (or, color shading), etc., and thereby enabling an improvement in the quality of the picture. In addition thereto, with such the flow channel structures as mentioned above, since the so-called liquid cooling cycle can be established, wherein the heat generated is discharged into an outside through the radiator 130 making up the heat radiation portion, while driving the liquid coolant by means of the pump 129, it is needless to say that the liquid crystal panel can be cooled down at higher cooling efficiency.

Although it is explained that the high-resistance flow channels are provided for achieving the throttle function mentioned above; i.e., the flat flow channels 15 and 16 (upper) and 10 and 11 (lower) having the thickness "d" (D>d), and further the buffer flow channels 17 and 18 (upper) and 10 and 11 (lower), respectively, on both sides (e.g., up and down) of the flat flow channels 6 and 7 having the thickness "D" in the explanation made in the above, however the present invention should not be restricted only to such the structures mentioned above, and therefore, only one of those may be provided only on the upstream side or the downstream side thereof.

In addition to the above, as the liquid coolant flowing in each of the flow channels mentioned above can be applied, for example, a water mixing an antifreezing solution, such as, ethylene glycol and/or propylene glycol, for example, in a part thereof, or alternatively, an inactive liquid of fluorine (par-chlorocarbon), such as, fluorinate (the trade mark of Sumitomo-3M company) representatively, for example, being superior in light permeability, inactive, and less in bubbling, and having electrical insulating property, as well. In particular, with application of the liquid coolant of the latter, it is possible to protect the projection picture from deterioration or degradation thereof, due to mixing of bubbles into the liquid coolant flowing in the flow channels within the liquid crystal panel area mentioned above, effectively. Also, in particular, upon the surface of the various substrates, building up the flat and flat flow channels 6 and 7 having the thickness "D", within the liquid crystal panel area, it is preferable to treat a process for maintaining hydrophilic nature or property thereof, such as, coating of a thin film of titan oxide, for example. With this, due to the function of photocalytic reaction of the titan oxide with the lights from the lamp mentioned above, the wall surfaces thereof can be kept to be hydrophilic, always; therefore, it is possible to restrain dusts and bubbles from adhering upon the said wall surface.

Further, it is preferable that, for example, the flat flow channel 16 of high resistance be determined so that the flowvelocity within the high-resistance flow channel 16 comes up to be equal about 10 times of an averaged flow velocity within the buffer flow channel 18, or higher than that. Preferably, those relating to the other buffer flow channels and the high-resistance flow channels are also determined in the similar manner. Also, the relationship between the thickness "D" of the flow channel 7 covering the liquid crystal panel area and the thickness "d" of the high-resistance flow channels 16 and 9 should not be limited, in particular, however since the present invention is applicable into the case where "D" is larger than "d"; therefore, it is preferable to determine "D" from 2mm to 5mm while "d" from 0.1mm to 1mm, approximately.

Also, in the embodiment mentioned above, explanation was made that the flat high-resistance flow channels 6 and 7, which are formed on both sides (e.g., the light incident side and the light emission side) of the liquid crystal panel 101, are equal to each other in the thickness "D" thereof. However, it is also possible to make the thickness differing from each other, thereby to change the flow velocity (e.g., the flow rate) of the liquid coolant within an inside thereof, for example, in a case when the heat generation on the light incident side surface of the liquid crystal panel 101 is lager than that on the light emission side, etc. And, in the similar manner, it is also possible to change, not only the thickness "D" of the flow channels 6 and 7, but also the thickness "d" of the flow channels 15 and 16 (upper) and 10 and 11 (lower), which are provided for forming the throttle, i.e., the high-resistance flow channels for the liquid coolant, and further the areas of the flow pass of the buffer flow channels 17 and 18 (upper) and 10 and 11 (lower), appropriately.

As was mentioned above, with the equalization and the stabilization of the coolant flowing through the liquid crystal panel, covering over the entire thereof, it is possible to obtain a good and preferable quality of pictures, without generating the fluctuations on the picture obtained, and also building up the liquid cooling system of discharging the heat generated inside the liquid crystal panel into an outside, actively, enables to cool down the liquid crystal panel at higher cooling efficiency. And, applying such the liquid crystal panels 101 into the liquid crystal panels 101(R), 101(G) and 101(B) for use of R, G and B, in the liquid crystal projector, it is possible to maintain a lifetime and reliability for those liquid crystal panels, in spite of an increase in an amount or volume of heat generation on the liquid crystal panels, accompanying with the small-sizing, silent operation, and high luminance or brightness thereof.

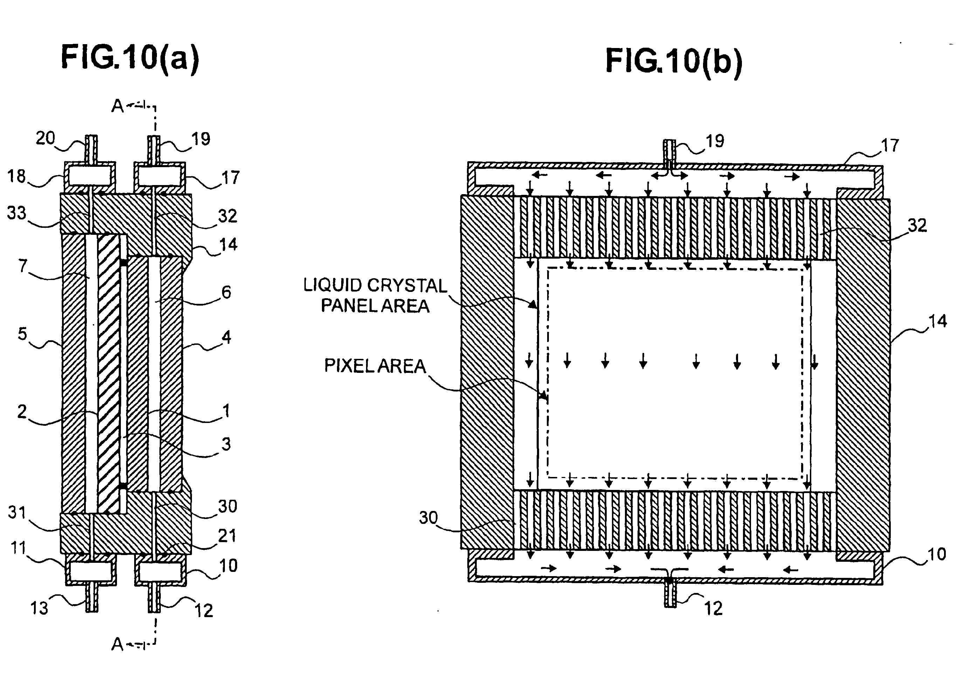

Next, Fig. 10(a) attached herewith shows a modification of the liquid crystal panel 101 shown in Figs. 8(a) and 8(b), by the cross-section view thereof, and also Fig. 10(b) shows the A-A cross-section view in Fig. 10(a) mentioned above. With the liquid crystal panel 101 according to this modification, in particular, the flow channels 8 and 9 (lower) and 15 and 16 (upper), which are formed in the top and bottom edge portions of the case 14 for building the frame surrounding the various substrates, are shaped, not into the slit-like as shown in Figs. 1(a) and 1(b) mentioned above, but into a plural number of circular through-holes 32. Further, with the structures of the liquid crystal panel 101 according to such the modification, in addition to the effects similar to those obtainable from the liquid crystal panel according to the above-mentioned embodiment, in particular, since the through-holes 32 are formed in the top and bottom edge portions of the case 14, in the places of the slit-like flow channels mentioned above, there can be obtained an effect that the manufacturing thereof comes to be easy, and also it is advantageous, in particular, when forming the flow channels to be in further high resistance within the flow channels 15 and 16 (upper) and 10 and 11 (lower) for forming the throttles for the liquid coolant.

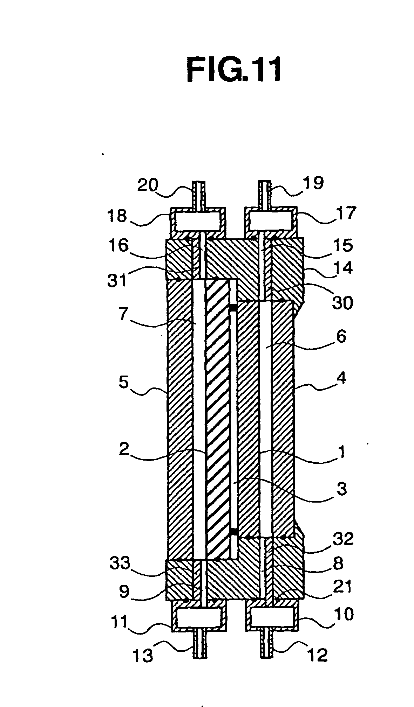

Next, Fig. 11 attachedherewith shows the cross-section view of the liquid crystal panel 101, according to other modification, further. With the liquid crystal panel 101 according to the other variation, as is apparent from the figure, the slit-like flow channels 8 and 9 (lower) and 15 and 16 (upper), which are formed in the top and bottom edge portions of the case 14 for building the frame surrounding the various substrates, are formed to be equal to the thickness "D" of the flow channels 6 and 7 covering the liquid crystal panel area mentioned above, in advance, and thereafter, resistance plates 30 and 31 (upper) and32 and33 (lower), each having a predetermined thickness, are attached on one side of the wall surfaces of those slit-like flow channels, thereby making up into the high-resistance flow channels having the thickness "d". However, with such the structures, for example, if determining the flat thickness of the resistance plates 30, 31, 32 or 33 to be fixed within the slit-like flow channels, which are formed in the top and bottom edge portions of the case 14 manufactured in advance, at a desirable value corresponding to the thickness "D" of the flow channels 6 and 7 covering the liquid crystal panel area, it is possible to build up the suitable high-resistance flow channels, easily, while obtaining the functions/effects mentioned above. Also, changing the thicknesses of the resistance plates 30, 31, 32 or 33, depending on the respective one of the flow channels 6 and 7 covering the liquid crystal panel area, it is also possible to change the flow velocity of the coolant within those flow channels 6 and 7.

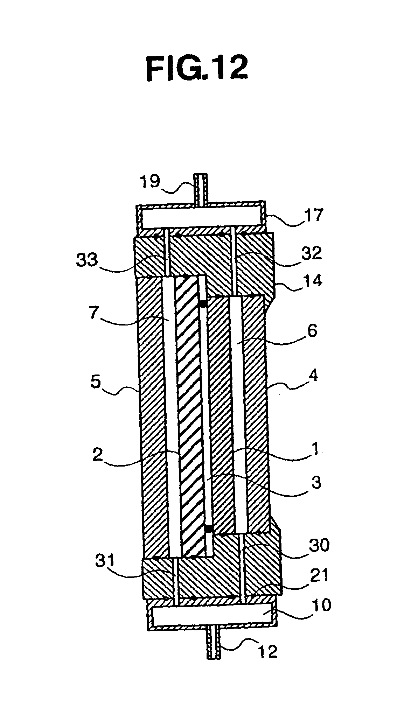

Further, Fig. 12 attached herewith shows the liquid crystal panel 101, according to further other embodiment of the present invention, by the cross-section view thereof. As is apparent from the figure, with the liquid crystal panel 101 according to this further other embodiment, the box-like members for forming the buffer flow channels therein, to be attached on the top and bottom edge portions of the case 14 for building the frame surrounding the various substrates, are formed together with, in one body. Thus, in the places of the two (2) pieces of box-like members 10 and 11 (lower) shown in Figs. 8(a) and 8(b), only one (1) piece of the box-like member 10 is attached, while attaching one (1) piece of the box-like member 17 in the places of the two (2) pieces of box-like members 17 and 18 (upper), and thereby forming the buffer flow channels on the top and bottom edge portions of the case 14, respectively. However, with such the structures, since the number of the constituent parts thereof can be reduced, it is possible to manufacture the liquid crystal panel, easily and cheaply, as well as, obtaining the functions/effects mentioned above.

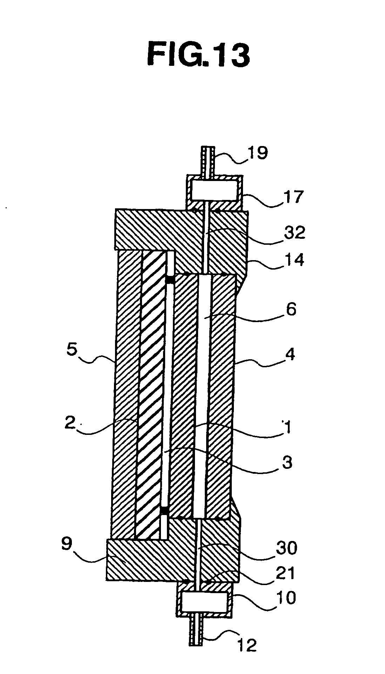

In addition thereto, Fig. 13 attached herewith shows the liquid crystal panel 101, according to further other embodiment of the present invention, by the cross-section view thereof. Further, as is apparent from the figure, with the liquid crystal panel 101 according to this further other embodiment, differing from the liquid crystal panel shown in Figs. 1(a) and 1(b) mentioned above, the flow channels for the liquid coolant, including the flat flow channel 6 being equal or uniform in the thickness "D" and the flat high-resistance flow channels 30 and 32 provided on both sides thereof, being equal or uniform in the thickness "d", are provided only on the light incident side of the liquid crystal panel 101. Thus, within the liquid crystal panel 101, being constructed with the TFT substrate 2 and the opposite substrate 1, enclosing or sealing the liquid crystal 3 between them, a flat flow channel 6, being equal or uniform in the thickness "D" thereof, is formed between that opposite substrate 1 and the protection glass plate 4 on the light incident side. However, on the other light emission side thereof, the protection glass plate 5 is directly connected on the TFT substrate 2. Also, on the top and bottom edge portions of the case 14 forming the frame surrounding those substrates, there is provided one (1) piece of flow channel 30 (lower) or 32 (upper), respectively, corresponding to the flat flow channel 6 being equal or uniform in the thickness "D" mentioned above, thereby building up the high-resistance flow channels having the thickness "d" mentioned above.

Further, with such the structures thereof, the liquid crystal panel can be manufactured, easily and cheaply, judging from the structures thereof, relatively, and an amount of heat generation thereof is also relatively small; therefore, it can be applied, preferably, in particular, in case where it is sufficient to remove the heat generation from only the light incident side of the liquid crystal panel.

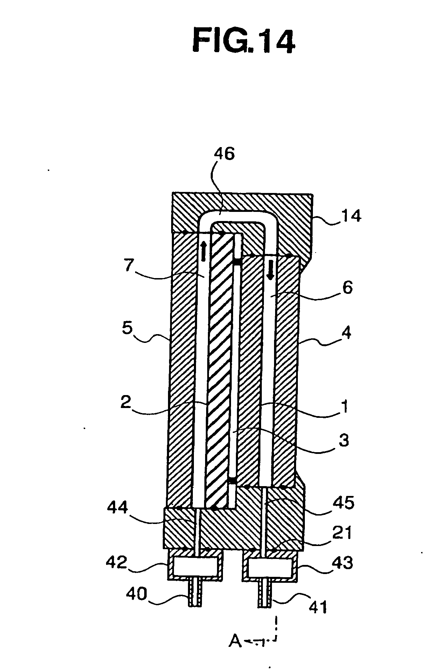

Finally, Fig. 14 attached herewith also shows the liquid crystal panel 101, according to further other embodiment of the present invention, by the cross-section view thereof. However, as is apparent from the figure, with the liquid crystal panel 101 according to this further other embodiment, in the top edge portion of the case 14 forming the frame is formed a flow channel having the thickness "D" similar to the flow channel 6, but being wound in the "U" shape, and it is connected to the other flow channel 7, on a while, in the bottom edge portion of the case 14 are formed the high-resistance flow channels 44 and 45 having the thickness "d", to be connected with the box-like members 42 and 42 for forming the buffer flow channels, respectively. Further, reference numerals 42 and 43 depict the introduction/delivery tubes for the liquid coolant.

With such the structures, differing from the liquid crystal panel 101 explained in the above, the introduction/delivery tubes for introducing or delivering the liquid coolant into/from the liquid crystal panel can be provided, not on both sides (i.e., un and down) of the panel, only one side thereof, for example, on the bottom side thereof in this example, and therefore, it is advantageous when pipes for the liquid coolant should be connected, in particular, being wound around within the narrow housing of the liquid crystal projector.

### Effects of the Invention

As apparent from the description mentioned above, first of all, with the liquid crystal projector, and further the liquid crystal panel and the liquid cooling apparatus for it, according to the present invention, it is possible to cool down the liquid crystal panels, effectively, with using the liquid cooling cycle circulating the liquid coolant therein, and further since difference in the density hardly generates within the liquid coolant flowing within the high-resistance flow channels covering the light transmitting surface of the liquid crystal panel, due to the differences in the velocity and the temperature thereof, therefore it is possible to obtain a good or preferable projection picture, without disturbing the picture projected. Further, it achieves an extremely superior effect that, in particular, the lifetime and/or the reliability thereof can be maintained high, including the liquid crystal panels thereof.

Secondary, with the liquid crystal projector, and further the liquid crystal panel and the liquid cooling apparatus for it, according to the present invention, it is possible to cool down the liquid crystal panels, effectively, with using the liquid cooling cycle circulating the liquid coolant therein, and further also since difference in the density hardly generates within the liquid coolant flowing within the high-resistance flow channels covering the light transmitting surface of the liquid crystal panel, due to the differences in the velocity and the temperature thereof, therefore it is possible to obtain a good or preferable projection picture, without disturbing the picture projected. Further, it achieves an extremely superior effect that, in particular, the lifetime and/or the reliability thereof can be maintained high, including the liquid crystal panels thereof.

## Claims

1. A liquid crystal panel for use in a liquid crystal projector, comprising:
two pieces of transparent substrates (1, 2), enclosing a liquid crystal (3) between them; and further
at least a transparent plate (4; 5), being disposed opposing to one surface (1; 2) of said two pieces of transparent substrates so as to form a flow channel for a liquid coolant between them, wherein
said flow channel defines a first high-resistance flow channel (6; 7) being flat and uniform in thickness thereof and covering a liquid crystal panel area of said liquid crystal panel,
**characterised in that**
said flow channel further comprises a buffer portion (10; 11; 17; 18) on one of upstream side and downstream side of said first high-resistance flow channel (6; 7).

2. A liquid crystal panel for use in a liquid crystal projector, comprising:
two pieces of transparent substrates (1, 2), enclosing a liquid crystal (3) between them; and further
at least a transparent plate (4;5), being disposed opposing to one surface of said two pieces of transparent substrates, so as to form a flow channel for a liquid coolant between them, wherein
said flow channel defines a first high-resistance flow channel (6; 7) being flat and uniform in thickness thereof and covering a liquid crystal panel area of said liquid crystal panel,
**characterised in that**
said flow channel further comprises an auxiliary flow channel (70; 71) lower in flow resistance than said first high-resistance flow channel, being formed on a periphery of said first high-resistance flow channel.

3. A liquid crystal projector, comprising:
a light source (112);
an optical element (113-116) for changing the light from said light source into a parallel light, to be divided into three light beams;
three kinds of liquid crystal panels (101) for transmitting the three light beams divided by said optical element therethrough, so as to modulate intensity thereof;
an optical synthesizing means (119) for synthesizing the three light beams, passing through said three kinds of liquid crystal panels, to be modulate intensity thereof;
a projection means (127) for projecting the three light beams, which are synthesized by said optical synthesizing means; and
a liquid cooling cycle, including a pump (129) and a radiator (130) therein, for circulating a liquid coolant within said three kinds of liquid crystal panels, so as to conduct cooling thereof,
wherein
each of said three kinds of liquid crystal panels is formed in accordance with claim 1 or 2

4. A liquid cooling apparatus for the cooling liquid crystal panel for use in a liquid crystal projector according to claim 3, comprising:
a driving means (129) for the liquid coolant, connected to said buffer portion of said liquid crystal panel; and
a heat radiator means (130) for radiating heat of said liquid crystal panel, which is received in said flow channel into an outside, whereby building a liquid cooling cycle.

## Patentansprüche

1. Flüssigkristall-Panel zur Verwendung in einem Flüssigkristall-Projektor, das aufweist:
zwei transparente Substrate (1, 2), zwischen denen ein Flüssigkristall (3) eingeschlossen ist, sowie
mindestens eine transparente Platte (4; 5), die so einer Oberfläche (1; 2) der beiden transparenten Substrate gegenüberliegend angeordnet ist, dass dazwischen ein Strömungskanal für ein flüssiges Kühlmittel gebildet wird,
wobei der Strömungskanal einen ersten Strömungskanal (6; 7) mit hohem Strömungswiderstand vorgibt, der flach und von gleichmäßiger Dicke ist und einen Flüssigkristall-Panel-Bereich des Flüssigkristall-Panels überdeckt,
**dadurch gekennzeichnet, dass**
der Strömungskanal ferner auf der stromaufwärts liegenden Seite oder auf der stromabwärts liegenden Seite des ersten Strömungskanals (6; 7) mit hohem Strömungswiderstand einen Pufferabschnitt (10; 11; 17; 18) aufweist.

2. Flüssigkristall-Panel zur Verwendung in einem Flüssigkristall-Projektor, das aufweist:
zwei transparente Substrate (1, 2), zwischen denen ein Flüssigkristall (3) eingeschlossen ist, sowie
mindestens eine transparente Platte (4; 5), die so einer Oberfläche der beiden transparenten Substrate gegenüberliegend angeordnet ist, dass dazwischen ein Strömungskanal für ein flüssiges Kühlmittel gebildet wird,
wobei der Strömungskanal einen ersten Strömungskanal (6; 7) mit hohem Strömungswiderstand vorgibt, der flach und von gleichmäßiger Dicke ist und einen Flüssigkristall-Panel-Bereich des Flüssigkristall-Panels überdeckt,
**dadurch gekennzeichnet, dass**
der Strömungskanal ferner einen zusätzlichen Strömungskanal (70; 71) aufweist, der einen geringerem Strömungswiderstand als der erste Strömungskanal mit hohem Strömungswiderstand aufweist und an einem Umfang des ersten Strömungskanals mit hohem Strömungswiderstand ausgebildet ist.

3. Flüssigkristall-Projektor, der aufweist:
eine Lichtquelle (112),
ein optisches Element (113 - 116) zur Umwandlung des Lichts von der Lichtquelle in paralleles Licht, das in drei Lichtstrahlen aufgeteilt wird,
drei Arten von Flüssigkristall-Panels (101), durch welche die drei durch das optische Element aufgeteilten Lichtstrahlen hindurchgeleitet werden, um ihre Intensität zu modulieren,
eine optische Syntheseeinrichtung (119) zum Zusammenführen der drei Lichtstrahlen, die durch die drei Arten von Flüssigkristall-Panels hindurchgehen, um ihre Intensität zu modulieren,
eine Projektionseinrichtung (127) zum Projizieren der drei Lichtstrahlen, die durch die optische Syntheseeinrichtung zusammengeführt werden,
und
einen Flüssigkeits-Kühlkreislauf, in dem eine Pumpe (129) und ein Wärmeabstrahlungs-Kühler (130) vorgesehen sind, um ein flüssiges Kühlmittel in den drei Arten von Flüssigkristall-Panels zirkulieren zu lassen, um sie zu kühlen,
wobei
jede der drei Arten von Flüssigkristall-Panels gemäß Anspruch 1 oder 2 ausgebildet ist.

4. Flüssigkeits-Kühlvorrichtung zum Kühlen des Flüssigkristall-Panels zur Verwendung in einem Flüssigkristall-Projektor nach Anspruch 3, die aufweist:
eine Antriebseinrichtung (129) für das flüssige Kühlmittel, die mit dem Pufferabschnitt des Flüssigkristall-Panels verbunden ist,
und
eine Wärmeabstrahlungseinrichtung (130) zum Abstrahlen von Wärme von dem Flüssigkristall-Panel, das in dem Strömungskanal angeordnet ist, nach außen, wodurch ein Flüssigkeits-Kühlkreislauf gebildet wird.

## Revendications

1. Panneau à cristaux liquides destiné à être utilisé dans un projecteur à cristaux liquides, comprenant :
deux pièces de substrats transparents (1, 2), entre lesquelles sont confinés des cristaux liquides (3) ; et
au moins une plaque transparente (4 ; 5), disposée face à une surface (1 ; 2) desdites deux pièces de substrats transparents afin de former entre elles un canal d'écoulement pour un réfrigérant liquide, dans lequel
ledit canal d'écoulement définit un premier canal d'écoulement haute résistance (6 ; 7) qui est plat et d'épaisseur uniforme et qui recouvre une zone de panneau à cristaux liquides dudit panneau à cristaux liquides,
**caractérisé en ce que**
ledit canal d'écoulement comprend en outre une partie tampon (10 ; 11 ; 17 ; 18) sur un côté en amont et un côté en aval dudit premier canal d'écoulement haute résistance (6 ; 7).

2. Panneau à cristaux liquides destiné à être utilisé dans un projecteur à cristaux liquides, comprenant :
deux pièces de substrats transparents (1, 2), entre lesquelles sont confinés des cristaux liquides (3) ; et
au moins une plaque transparente (4 ; 5), disposée face à une surface desdites deux pièces de substrats transparents afin de former entre les deux un canal d'écoulement pour un réfrigérant liquide, dans lequel
ledit canal d'écoulement définit un premier canal d'écoulement haute résistance (6 ; 7) qui est plat et d'épaisseur uniforme et qui recouvre une zone de panneau à cristaux liquides dudit panneau à cristaux liquides,
**caractérisé en ce que**
ledit canal d'écoulement comprend en outre un canal d'écoulement auxiliaire (70 ; 71) ayant une résistance à l'écoulement inférieure à celle dudit premier canal d'écoulement haute résistance, formé sur la périphérie dudit premier canal d'écoulement haute résistance.

3. Projecteur à cristaux liquides, comprenant :
une source lumineuse (112) ;
un élément optique (113-116) qui permet de changer la lumière provenant de ladite source lumineuse en lumière parallèle, devant être divisée en trois faisceaux lumineux ;
trois types de panneaux à cristaux liquides (101) permettant de transmettre les trois faisceaux lumineux divisés par ledit élément optique à travers ceux-ci, afin d'en moduler l'intensité ;
un moyen de synthétisation optique (119) qui permet de synthétiser les trois faisceaux lumineux, traversant lesdits trois types de panneaux à cristaux liquides, afin d'en moduler l'intensité ;
un moyen de projection (127) qui permet de projeter les trois faisceaux lumineux, qui sont synthétisés par ledit moyen de synthétisation optique ; et
un cycle de refroidissement par liquide, incluant une pompe (129) et un élément rayonnant (130), permettant de faire circuler un réfrigérant liquide dans lesdits trois types de panneaux à cristaux liquides afin de les refroidir,
chacun desdits trois types de panneaux à cristaux liquides étant formé conformément à la revendication 1 ou 2.

4. Appareil de refroidissement par liquide pour le panneau à cristaux liquides destiné à être utilisé dans un projecteur à cristaux liquides selon la revendication 3, comprenant :
un moyen d'entraînement (129) pour le réfrigérant liquide, relié à ladite partie tampon dudit panneau à cristaux liquides ; et
un moyen de rayonnement thermique (130) permettant de diffuser la chaleur dudit panneau à cristaux liquides, qui est reçue dans ledit canal d'écoulement, vers l'extérieur, ce qui permet d'établir un cycle de refroidissement par liquide.
